# EUROPÄISCHE PATENTSCHRIFT

(11) **EP 4 012 366 B1**
(45) Veröffentlichungstag und Bekanntmachung des Hinweises auf die Patenterteilung: **07.06.2023**
(21) Anmeldenummer: 21210004.4
(22) Anmeldetag: 23.11.2021
(51) Int. Cl.: G01K 11/322, G01D 5/353, G01K 15/00, G01L 1/24, G01J 3/44, H03M 1/12

(54) **VORRICHTUNG UND VERFAHREN ZUR DIGITALISIERUNG EINES OPTISCHEN SIGNALS SOWIE ZUR ORTSAUFGELÖSTEN MESSUNG VON TEMPERATUR UND DEHNUNG VERMITTELS BRILLOUIN-STREUUNG**
DEVICE AND METHOD FOR DIGITIZING AN OPTICAL SIGNAL AND FOR LOCALLY RESOLVED MEASUREMENT OF TEMPERATURE AND ELONGATION BY MEANS OF BRILLOUIN SCATTERING
DISPOSITIF ET PROCÉDÉ DE NUMÉRISATION D'UN SIGNAL OPTIQUE, AINSI QUE DE MESURE À RÉSOLUTION LOCALE DE LA TEMPÉRATURE ET DE LA DILATATION PAR DIFFUSION DE BRILLOUIN

(30) Priorität: 03.12.2020 DE 102020132210
(43) Veröffentlichungstag der Anmeldung: 15.06.2022
(73) Patentinhaber: NKT Photonics GmbH, 51063 Köln (DE)
(72) Erfinder: Dr. Hill, Wieland, 51519 Odenthal (DE); Rath, Alexander, 52393 Hürtgenwald (DE); Dr. Marx, Benjamin, 50733 Köln (DE); Dr. Jostmeier, Thorben, 42781 Haan (DE)
(74) Vertreter: Schäperklaus, Jochen

(56) Entgegenhaltungen:
- EP-A1- 3 139 133
- US-A1- 2008 316 494
- US-A1- 2011 090 936

## Beschreibung

Die vorliegende Erfindung betrifft eine Vorrichtung und ein Verfahren zur Digitalisierung eines optischen Signals sowie eine Vorrichtung zur ortsaufgelösten Messung von Temperatur und Dehnung vermittels Brillouin-Streuung gemäß dem Oberbegriff des Anspruchs 12 und ein Verfahren zur ortsaufgelösten Messung von Temperatur und Dehnung vermittels Brillouin-Streuung gemäß dem Oberbegriff des Anspruchs 13.

Vorrichtungen und Verfahren zur ortsaufgelösten Messung von Temperatur und Dehnung vermittels Brillouin-Streuung der vorgenannten Art sind aus der EP 3 139 133 A1 bekannt. Bei der darin beschriebenen Vorrichtung wird die von einer Laserlichtquelle ausgehende Laserstrahlung in eine zur Messung verwendete Lichtleitfaser eingekoppelt. Die von der Laserstrahlung in der Lichtleitfaser aufgrund von Brillouin-Streuung erzeugten Brillouin-Signale werden ausgekoppelt. Von einem optischen Polarisationsstrahlteiler werden die ausgekoppelten Brillouin-Signale in zwei Komponenten mit voneinander verschiedenen Polarisationen aufgespalten, wobei von einem optischen Koppler den einzelnen Komponenten des Brillouin-Signals jeweils eine Laserstrahlung hinzugemischt wird. Diese gemischten Signale werden getrennt voneinander von beispielsweise als Photodetektoren ausgebildeten Sensormitteln erfasst. Es sind weiterhin Auswertemittel vorgesehen, die aus den erfassten Brillouin-Signalen die Temperatur und die Dehnung von Abschnitten der Lichtleitfaser ortsaufgelöst bestimmen können. Dabei wird von den Auswertemitteln jeweils die Frequenz des Brillouin-Signals erfasst.

Brillouin-Streuung in Lichtleitfasern kann zur verteilten beziehungsweise ortsaufgelösten Messung von Temperatur und Dehnung entlang der Lichtleitfaser benutzt werden, weil die Frequenz und die Amplitude der Brillouin-Streuung eine Funktion der Messgrößen Temperatur und Dehnung sind.

Häufig wird nur die Brillouin-Frequenz gemessen, die sehr empfindlich, beispielsweise mit etwa 1 MHz/°C beziehungsweise 0,05 MHz/µε in Quarzglas, von den Messgrößen abhängt und sehr genau bestimmt werden kann. Allerdings besteht dabei das Problem, den Einfluss der beiden Messgrößen Temperatur und Dehnung zu trennen.

Eine Trennung beider Messgrößen ist in einigen Fällen durch vergleichende Messungen in unterschiedlich eingebauten Lichtleitfasern wie beispielsweise Bündelader mit loser Faser oder Festader mit fester Faser möglich (siehe dazu: Inaudi & Glisic, 2006, Reliability and field testing of distributed strain and temperature sensors, 6167, 61671 D-61671 D-8). Alternativ können auch Messungen der Brillouin-Frequenzen entweder in Fasern mit mehreren Brillouin-Peaks (siehe dazu: Liu & Bao, 2012, Brillouin Spectrum in LEAF and Simultaneous Temperature and Strain Measurement. J. Lightwave Technol., 30(8), 1053-1059) oder Oligomodefasern mit wenigen unterschiedlichen räumlichen Moden (siehe dazu: Weng, Ip, Pan, & Wang, 2015, Single-end simultaneous temperature and strain sensing techniques based on Brillouin optical time domain reflectometry in few-mode fibers, Opt. Express, 23(7), 9024-9039) mit unterschiedlichen Abhängigkeiten der Frequenz von Temperatur und Dehnung zur Trennung der Messgrößen genutzt werden.

Sämtliche dieser Methoden sind aber nicht allgemein einsetzbar, weil nicht immer geeignete Lichtleitfasern in der Anwendung verfügbar sind. Außerdem ist die Verlegung und Messung mehrerer Lichtleitfasern oder von Spezialfasern mit erhöhtem Aufwand verbunden.

Eine weitere Methode zur Trennung beider Messgrößen ist die Messung von Frequenz und Amplitude eines oder mehrerer Brillouin-Peaks. Beispiele für die Messung von Frequenz und Amplitude eines oder mehrerer Brillouin-Peaks finden sich in Parker, Farhadiroushan, Handerek, & Rogers, 1997, Temperature and strain dependence of the power level and frequency of spontaneous Brillouin scattering in optical fibers, Opt. Lett., 22(11), 787-789 sowie in Maughan, Kee, & Newson, 2001, Simultaneous distributed fibre temperature and strain sensor using microwave coherent detection of spontaneous Brillouin backscatter, Measurement Science and Technology, 12(7), 834.

Durch die Messung von Frequenz und Amplitude eines oder mehrerer Brillouin-Peaks werden zwei unabhängige Messgrößen erhalten, aus denen grundsätzlich die beiden gesuchten physikalischen Parameter Temperatur und Dehnung bestimmt werden können. Allerdings ist die Abhängigkeit der Amplitude von Temperatur und Dehnung schwach und liegt beispielsweise bei etwa 0,3%/°C. Deshalb muss die Amplitude sehr genau gemessen werden, um praktisch relevante Temperaturauflösungen und -genauigkeiten von etwa 1°C zu erreichen.

Insbesondere bei der Trennung beider Messgrößen anhand der Frequenzen mehrerer Brillouin-Peaks erweist es sich als problematisch, dass die Koeffizienten der Frequenzen hinsichtlich Temperatur- und Dehnungsabhängigkeit für die verschiedenen Peaks in einer Faser recht ähnlich sind. Deshalb vergrößert sich das Rauschen beim Auseinanderrechnen der Messgrößen erheblich.

Weiterhin muss für die Nutzung der Brillouin-Streuung zur Temperatur- und Dehnungsmessung in Brillouin-DTS (distributed temperature sensing) die Amplitude linear über einen großen dynamischen Bereich wie beispielsweise 20 dB oder 30 dB gemessen werden. Dies hat seinen Grund einerseits darin, dass die Dämpfung von Lichtwellenleitern und Verluste an Steckern, Spleißen und anderen Arten von Faserverbindungen die Signalamplitude mit zunehmender Faserlänge verringern. Bei einer typischen Faserlänge von 100 km und einer Dämpfung von 0,2 dB/km beträgt der Gesamtverlust in einer Richtung ohne Verbindungen bereits 20 dB. Andererseits erzeugen Effekte wie Polarisationsfading eine zusätzliche Variation der Signalpegel, die ebenfalls durch den Dynamikbereich eines Detektors abgedeckt werden muss.

Das der vorliegenden Erfindung zugrunde liegende Problem ist die Schaffung einer Vorrichtung der eingangs genannten Art zur Digitalisierung eines optischen Signals und die Angabe eines Verfahrens der eingangs genannten Art zur Digitalisierung eines optischen Signals, mit der Amplituden eines optischen Signals sehr genau und/oder in einem großen Dynamikbereich ermittelt werden können. Weiterhin liegt der vorliegenden Erfindung das Problem zugrunde, eine Vorrichtung der eingangs genannten Art zur ortsaufgelösten Messung von Temperatur und Dehnung vermittels Brillouin-Streuung zu schaffen und ein Verfahren der eingangs genannten Art zur ortsaufgelösten Messung von Temperatur und Dehnung vermittels Brillouin-Streuung anzugeben, mit denen einfacher und/oder genauer die Temperatur und die Dehnung bestimmt werden können.

Dies wird erfindungsgemäß durch eine Vorrichtung der eingangs genannten Art zur Digitalisierung eines optischen Signals mit den Merkmalen des Anspruchs 1, durch ein Verfahren der eingangs genannten Art zur Digitalisierung eines optischen Signals mit den Merkmalen des Anspruchs 7 sowie durch eine Vorrichtung der eingangs genannten Art zur ortsaufgelösten Messung von Temperatur und Dehnung vermittels Brillouin-Streuung mit den kennzeichnenden Merkmalen des Anspruchs 12 und durch ein Verfahren der eingangs genannten Art zur ortsaufgelösten Messung von Temperatur und Dehnung vermittels Brillouin-Streuung mit den kennzeichnenden Merkmalen des Anspruchs 13 erreicht. Die Unteransprüche betreffen bevorzugte Ausgestaltungen der Erfindung.

Gemäß Anspruch 1 umfasst die Vorrichtung
- einen optischen Detektor, insbesondere einen Photodetektor, der dazu eingerichtet ist, ein optisches Signal zu erfassen und ein dem optischen Signal entsprechendes elektrisches Signal zu erzeugen,
- einen Hüllkurvendetektor, der dazu eingerichtet ist, die Amplitude des von dem optischen Detektor erzeugten elektrischen Signals oder die Amplitude eines aus diesem elektrischen Signal hervorgegangenen elektrischen Signals zu bestimmen und ein dieser Amplitude entsprechendes elektrisches Signal auszugeben,
- einen Analog-Digital-Wandler, der dazu eingerichtet ist, das von dem Hüllkurvendetektor ausgegebene elektrische Signal zu digitalisieren und entsprechende Daten auszugeben,
- eine variable Spannungsquelle mit einem Ausgang, der mit einem Eingang des Hüllkurvendetektors verbunden oder verbindbar ist, wobei die Vorrichtung dazu eingerichtet ist, den Hüllkurvendetektor mit der variablen Spannungsquelle zu kalibrieren.

Da der Einfluss von Temperatur- und Dehnungseffekten auf die Amplitude von Brillouin-Signalen ziemlich schwach ist, sind sehr genaue Amplitudenmessungen erforderlich, um eine ausreichende Temperaturauflösung und Genauigkeit mit einer amplituden- und frequenzbasierten Brillouin-DTS zu erhalten. Eine solche Präzision können nicht kalibrierte Hüllkurvendetektoren nicht bieten.

Bei einer linearen Messung wird eine bestimmte Änderung des optischen Brillouin-Signals in eine bestimmte Änderung der gemessenen Spannung umgewandelt, die unabhängig von der absoluten Signalstärke ist. Um eine korrekte Temperatur- und Dehnungsmessung an beliebigen Stellen in der Faser durchzuführen, ist eine lineare Messung über einen großen dynamischen Bereich erforderlich. Nicht kalibrierte Hüllkurvendetektoren können auch eine solche Linearität nicht bieten.

Beispielsweise wandeln BOTDR-DTS (Brillouin optical time domain reflectometry distributed temperature sensing) im Allgemeinen das optische Brillouin-Signal in ein elektrisches Hochfrequenzsignal um und filtern sowie verstärken dieses Signal dann. Die Amplitude eines solchen Signals kann mit Hilfe eines Hüllkurvendetektors bestimmt werden. Ein Hüllkurvendetektor entfernt die Trägerfrequenz aus dem Signal und ermöglicht es, die Amplitude bei der niedrigeren Signalmodulationsfrequenz abzutasten und/oder zu digitalisieren. Im Prinzip wird das Hochfrequenzsignal gleichgerichtet und dann zur Glättung gefiltert. Es gibt verschiedene Ausführungen von Hüllkurvendetektoren, wie Voll- oder Halbwellengleichrichtung, verschiedene Filter oder aktive Präzisionsgleichrichter mit Operationsverstärkern. Alle diese Designs haben starke Einschränkungen hinsichtlich Nichtlinearität und Temperaturabhängigkeit der Ausgangssignale.

Die Nichtlinearität bei kleinen Signalamplituden stammt hauptsächlich von der Schwellenspannung von Gleichrichterdioden, die in den Detektoren verwendet werden. Diese Schwelle verhindert die Erkennung schwacher Signale und macht die Diodeneigenschaften bei niedrigen Spannungen nichtlinear. Diese Begrenzung wird durch aktive Gleichrichter teilweise überwunden, aber nicht vollständig beseitigt. Aktive Gleichrichter verwenden dabei Verstärkerschaltungen, die andere Probleme wie Temperaturdrift, Signaloffset oder spannungsabhängige Verstärkung haben können.

Bei hohen Signalen kann Nichtlinearität durch abnehmende Verstärkung bei Ausgangsspannungen entstehen, die sich dem Versorgungsspannungsniveau nähern. Weiterhin kann eine Temperaturabhängigkeit des Verstärkerausgangs durch Offset- oder Verstärkungsschwankungen im Zusammenhang mit temperaturabhängigen aktiven oder passiven Komponenten wie Transistoren oder Widerständen entstehen. Ein weiteres Problem ist die Variation der Eigenschaften der Komponenten, die zu leicht unterschiedlichen Verstärkungsprofilen für verschiedene Detektoren oder Verstärker innerhalb einer Charge oder von Charge zu Charge führen können.

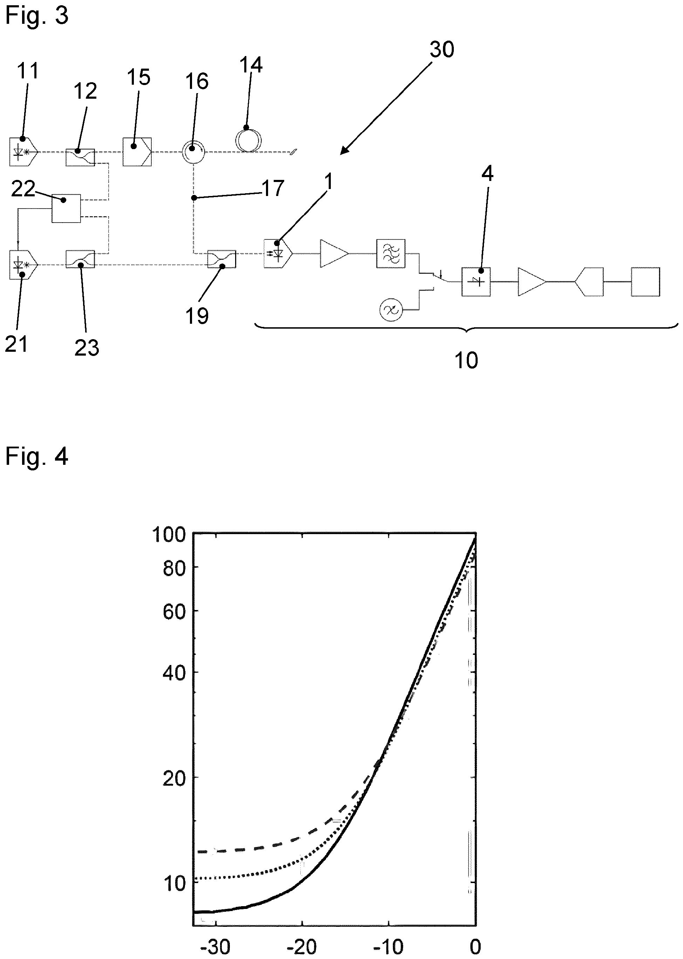

Die Temperaturabhängigkeit eines typischen Hüllkurvendetektors zeigt beispielhaft Fig. 4. Dabei ist auf der Abszisse die Stärke des Eingangssignals in dB und auf der Ordinate das Ausgangssignal in willkürlichen Einheiten dargestellt ist. Die durchgezogene Linie entspricht einer Temperatur des Hüllkurvendetektors von 5 °C, die gepunktete Linie einer Temperatur des Hüllkurvendetektors von 25 °C und die gestrichelte Linie einer Temperatur des Hüllkurvendetektors von 55 °C. Es zeigt sich insbesondere bei sehr kleinen Signalen eine starke Nichtlinearität und eine große Temperaturabhängigkeit des Ausgangs von der Temperatur.

Durch die erfindungsgemäß vorgesehene variable Spannungsquelle kann der Hüllkurvendetektor so kalibriert werden, dass trotz einer typischen starken Nichtlinearität und Temperaturabhängigkeit des Hüllkurvendetektors eine vergleichsweise genaue Messung über einen großen Dynamikbereich ermöglicht wird.

Es besteht die Möglichkeit, dass die Spannungsquelle dazu eingerichtet ist, ein variables Spannungssignal zu generieren, das die gleiche oder eine ähnliche Frequenz wie das elektrische Signal aufweist, das aus dem optischen Signal erzeugt wird. Insbesondere können die von der variablen Spannungsquelle erzeugten Spannungssignale in einem Frequenzbereich liegen, der gleich, kleiner oder größer ist als der Frequenzbereich der aus dem optischen Signal erzeugten elektrischen Signale. Insbesondere kann dabei der Frequenzbereich der von der variablen Spannungsquelle erzeugten Spannungssignale den Frequenzbereich der aus dem optischen Signal erzeugten elektrischen Signale abdecken. Alternativ können die von der variablen Spannungsquelle erzeugten Spannungssignale auch nur eine einzelne Frequenz oder einen schmalen Frequenzbereich aufweisen, der in dem Frequenzbereich der aus dem optischen Signal erzeugten elektrischen Signale liegt.

Beispielsweise kann der Frequenzbereich der aus dem optischen Signal erzeugten elektrischen Signale zwischen 823,5 MHz und 935 MHz liegen. In diesem Fall können die von der variablen Spannungsquelle erzeugten Spannungssignale in einem Frequenzbereich liegen, der mindestens von 823,5 MHz bis 935 MHz reicht. Es besteht dabei durchaus die Möglichkeit, dass der Frequenzbereich der von der variablen Spannungsquelle erzeugten Spannungssignale größer ist, also beispielsweise von 800 MHz bis 960 MHz reicht. Alternativ kann bei diesem Beispiel auch vorgesehen sein, dass der Frequenzbereich der von der variablen Spannungsquelle erzeugten Spannungssignale kleiner ist und innerhalb des Frequenzbereichs der aus dem optischen Signal erzeugten elektrischen Signale liegt. Beispielsweise können die von der variablen Spannungsquelle erzeugten Spannungssignale eine konstante Frequenz von 890 MHz +/- 3 ppm aufweisen.

Neben der Brillouin-DTS kann die erfindungsgemäße Vorrichtung zur Digitalisierung eines optischen Signals für zahlreiche weitere Anwendungen genutzt werden, die präzise Messungen der Amplitude hochfrequenter optischer oder elektrischer Signale erfordern.

Es kann vorgesehen sein, dass die Vorrichtung einen Bandpassfilter umfasst, der zwischen dem optischen Detektor und dem Hüllkurvendetektor angeordnet ist, wobei der Bandpassfilter dazu eingerichtet ist, aus dem von dem optischen Detektor erzeugten elektrischen Signal einen Gleichstromanteil und/oder mindestens einen Frequenzbereich herauszufiltern, der bei der Bestimmung der Amplitude durch den Hüllkurvendetektor nicht benötigt wird und/oder sich als störend erweist. Weiterhin kann die Vorrichtung einen Verstärker umfassen, der zwischen dem optischen Detektor und dem Hüllkurvendetektor oder zwischen dem optischen Detektor und dem Bandpassfilter angeordnet ist, wobei der Verstärker dazu eingerichtet ist, das von dem optischen Detektor erzeugte elektrische Signal zu verstärken, wobei der Verstärker insbesondere ein Transimpedanz-Verstärker ist.

Es besteht die Möglichkeit, dass die Vorrichtung einen Schalter umfasst, der einerseits zwischen dem optischen Detektor oder dem Verstärker oder dem Bandpassfilter und dem Hüllkurvendetektor sowie andererseits zwischen der variablen Spannungsquelle und dem Hüllkurvendetektor angeordnet ist, wobei der Schalter dazu eingerichtet ist, entweder das mittelbar oder unmittelbar von dem optischen Detektor erzeugte elektrische Signal auf den Eingang des Hüllkurvendetektors zu geben oder den Ausgang der variablen Spannungsquelle mit dem Eingang des Hüllkurvendetektors zu verbinden.

Es kann vorgesehen sein, dass die Vorrichtung einen Verstärker umfasst, der zwischen dem Hüllkurvendetektor und dem Analog-Digital-Wandler angeordnet ist, wobei der Verstärker dazu eingerichtet ist, das von dem Hüllkurvendetektor erzeugte elektrische Signal zu verstärken.

Es besteht die Möglichkeit, dass die Vorrichtung eine digitale Verarbeitungsvorrichtung umfasst, die dazu eingerichtet ist, bei der Kalibrierung des Hüllkurvendetektors erzeugte Kalibrierdaten zu speichern und unter Verwendung dieser Kalibrierdaten die von dem Analog-Digital-Wandler ausgegebenen Daten zu normalisieren.

Gemäß Anspruch 7 umfasst das Verfahren folgende Verfahrensschritte:
- Es wird ein optisches Signal erfasst und ein dem optischen Signal entsprechendes elektrisches Signal erzeugt,
- von einem Hüllkurvendetektor wird die Amplitude des erzeugten elektrischen Signals oder die Amplitude eines aus diesem elektrischen Signal hervorgegangenen elektrischen Signals bestimmt und ein dieser Amplitude entsprechendes elektrisches Signal ausgegeben,
- das von dem Hüllkurvendetektor ausgegebene elektrische Signal wird digitalisiert und der Digitalisierung entsprechende Daten werden ausgegeben,
- mit einer variablen Spannungsquelle wird der Hüllkurvendetektor kalibriert.

Dabei kann vorgesehen sein, dass bei der Kalibrierung des Hüllkurvendetektors von der variablen Spannungsquelle mehrere voneinander verschiedene Spannungen erzeugt werden, die auf einen Eingang des Hüllkurvendetektors gegeben werden. Vorzugsweise kann dabei die Spannungsquelle für die Kalibrierung des Hüllkurvendetektors und etwaiger Verstärker hinter der Schalterstellung über den gesamten zu messenden Spannungsbereich verwendet werden. Die Spannungsquelle sollte dabei möglichst ein variables Spannungssignal mit der gleichen oder einer ähnlichen Frequenz wie die zu detektierende Photospannung liefern. Weiterhin sollte der Ausgang der Spannungsquelle über den gesamten Bereich der zu erwartenden Photospannungen einstellbar sein.

Es besteht die Möglichkeit, dass die Spannungsquelle ein variables Spannungssignal generiert, das die gleiche oder eine ähnliche Frequenz wie das elektrische Signal aufweist, das aus dem optischen Signal erzeugt wird. Insbesondere können die von der variablen Spannungsquelle erzeugten Spannungssignale in einem Frequenzbereich liegen, der gleich, kleiner oder größer ist als der Frequenzbereich der aus dem optischen Signal erzeugten elektrischen Signale. Insbesondere kann dabei der Frequenzbereich der von der variablen Spannungsquelle erzeugten Spannungssignale den Frequenzbereich der aus dem optischen Signal erzeugten elektrischen Signale abdecken. Alternativ können die von der variablen Spannungsquelle erzeugten Spannungssignale auch nur eine einzelne Frequenz oder einen schmalen Frequenzbereich aufweisen, der in dem Frequenzbereich der aus dem optischen Signal erzeugten elektrischen Signale liegt.

Beispielsweise kann der Frequenzbereich der aus dem optischen Signal erzeugten elektrischen Signale zwischen 823,5 MHz und 935 MHz liegen. In diesem Fall können die von der variablen Spannungsquelle erzeugten Spannungssignale in einem Frequenzbereich liegen, der mindestens von 823,5 MHz bis 935 MHz reicht. Es besteht dabei durchaus die Möglichkeit, dass der Frequenzbereich der von der variablen Spannungsquelle erzeugten Spannungssignale größer ist, also beispielsweise von 800 MHz bis 960 MHz reicht. Alternativ kann bei diesem Beispiel auch vorgesehen sein, dass der Frequenzbereich der von der variablen Spannungsquelle erzeugten Spannungssignale kleiner ist und innerhalb des Frequenzbereichs der aus dem optischen Signal erzeugten elektrischen Signale liegt. Beispielsweise können die von der variablen Spannungsquelle erzeugten Spannungssignale eine konstante Frequenz von 890 MHz +/- 3 ppm aufweisen.

Es kann weiterhin vorgesehen sein, dass die Kalibrierung des Hüllkurvendetektors bei mehreren voneinander verschiedenen Temperaturen des Hüllkurvendetektors durchgeführt wird. Die Kalibrierung kann bei jeder Temperatur innerhalb des zu erwartenden Bereichs der Betriebstemperaturen des Empfängers durchgeführt werden. Ein solches Schema kann jegliche Nichtlinearitäts- und Temperatureffekte auf die Empfängerkomponenten hinter der Schalterstellung nahezu vollständig auslöschen.

Um die Genauigkeit der Messung weiter zu erhöhen, kann durchaus vorgesehen werden, die variable Spannungsquelle vor ihrer Benutzung ebenfalls zu kalibrieren.

Es besteht die Möglichkeit, dass bei der Kalibrierung des Hüllkurvendetektors Kalibrierdaten erzeugt werden, die abgespeichert und zur Normalisierung der ausgegebenen Daten verwendet werden.

Insbesondere kann vorgesehen sein, dass die Kalibrierung während der Herstellung oder Wartung der Vorrichtung durchgeführt wird oder dass die Kalibrierung zwischen verschiedenen aufeinanderfolgenden Digitalisierungen optischer Signale durchgeführt wird. Die Spannungsquelle kann dauerhaft oder vorübergehend an den Empfänger angeschlossen sein. Eine vorübergehend angeschlossene Spannungsquelle kann zur Kalibrierung während der Herstellung oder Wartung der Vorrichtung verwendet werden. Die vollständigen Kalibrierdaten werden dann in der digitalen Verarbeitungsvorrichtung der Vorrichtung gespeichert und zur numerischen Kalibrierung oder Korrektur der Signale verwendet. Eine fest integrierte Spannungsquelle kann für die Aufnahme von Kalibrierdaten zu jedem geeigneten Zeitpunkt zwischen den Lichtmessungen verwendet werden. Eine solche Kalibrierung mit einer integrierten Quelle kann präziser sein, weil sie sich auf den aktuellen Zustand der Systeme bezieht.

Gemäß Anspruch 12 ist vorgesehen, dass die Vorrichtung zur Digitalisierung eines optischen Signals eine erfindungsgemäße Vorrichtung zur Digitalisierung eines optischen Signals ist.

Gemäß Anspruch 13 ist vorgesehen, dass die Vorrichtung zur Digitalisierung eines optischen Signals eine erfindungsgemäße Vorrichtung zur Digitalisierung eines optischen Signals ist.

Es kann vorgesehen sein, dass sowohl die Frequenz als auch die Amplitude der Brillouin-Signale bestimmt werden. Dabei können nacheinander die Amplituden der Brillouin-Signale bei verschiedenen Frequenzen gemessen werden und danach eine Peakfrequenz aus einem Peakfit der Amplituden über der Frequenz bestimmt werden.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen:
- Fig. 1: eine schematische Darstellung einer erfindungsgemäßen Vorrichtung zur Digitalisierung eines optischen Signals;
- Fig. 2: eine schematische Darstellung einer ersten Ausführungsform einer erfindungsgemäßen Vorrichtung zur ortsaufgelösten Messung von Temperatur und Dehnung vermittels Brillouin-Streuung;
- Fig. 3: eine schematische Darstellung einer zweiten Ausführungsform einer erfindungsgemäßen Vorrichtung zur ortsaufgelösten Messung von Temperatur und Dehnung vermittels Brillouin-Streuung;
- Fig. 4: ein Diagramm, dass die Temperaturabhängigkeit eines Hüllkurvendetektors zeigt, wobei auf der Abszisse die Stärke des Eingangssignals in dB und auf der Ordinate das Ausgangssignal in willkürlichen Einheiten dargestellt ist.

In den Figuren sind gleiche oder funktional gleiche Teile mit gleichen Bezugszeichen versehen. Die gestrichelten Verbindungslinien repräsentieren optische Signale, die vorzugsweise in Lichtleitern geführt werden. Die durchgezogenen Verbindungslinien repräsentieren elektrische Signalleitungen.

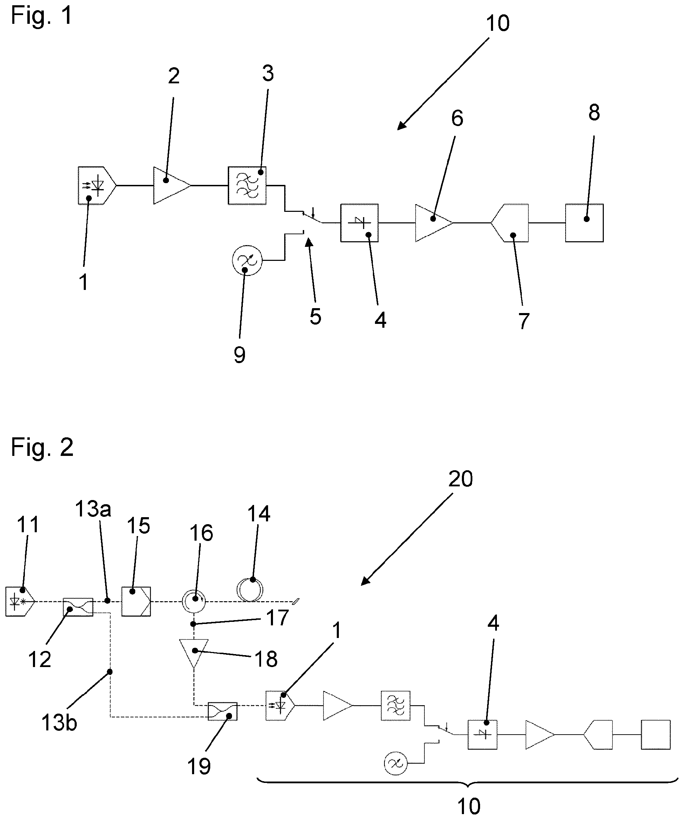

Die in Fig. 1 abgebildete Ausführungsform einer Vorrichtung 10 zur Digitalisierung eines optischen Signals umfasst einen optischen Detektor 1, der beispielsweise ein hochfrequentes, amplitudenmoduliertes optisches Signal empfängt und einen Photostrom erzeugt.

Die Vorrichtung 10 umfasst weiterhin einen oder mehrere Verstärker 2, der als Transimpedanz-Verstärker ausgebildet ist. Der Verstärker 2 ist optional und kann auch weggelassen werden. Der mindestens eine Verstärker 2 verstärkt das von dem optischen Detektor 1 erzeugte elektrische Signal und wandelt dabei den Strom in eine Spannung um.

Es besteht durchaus die Möglichkeit, dass der als Transimpedanz-Verstärker ausgebildete Verstärker in den optischen Detektor 1 integriert ist. In diesem Fall wird der Photostrom im optischen Detektor 1 in ein Spannungssignal umgewandelt, das am Ausgang des optischen Detektors 1 anliegt.

Die Vorrichtung umfasst weiterhin einen Bandpassfilter 3, der aus dem verstärkten Signal einen Gleichstromanteil und bei der weiteren Verarbeitung nicht benötigte beziehungsweise störende Frequenzbereiche herausfiltert.

Die Vorrichtung 10 umfasst weiterhin einen Hüllkurvendetektor 4, dessen Eingang über einen Schalter 5 mit dem Ausgang des Bandpassfilters 3 verbunden ist. Der Schalter 5 ist optional und kann auch weggelassen werden.

Der Hüllkurvendetektor 4 bestimmt die Amplitude des von dem Bandpassfilter 3 gefilterten elektrischen Signals und gibt ein dieser Amplitude entsprechendes elektrisches Signal aus. Dabei entfernt der Hüllkurvendetektor 4 die Trägerfrequenz aus dem Signal und ermöglicht es, die Amplitude bei der niedrigeren Signalmodulationsfrequenz abzutasten und/oder zu digitalisieren. Im Prinzip wird das Hochfrequenzsignal gleichgerichtet und dann zur Glättung gefiltert.

Die Vorrichtung 10 umfasst weiterhin einen Verstärker 6, der das von dem Hüllkurvendetektor 4 ausgegebene elektrische Signal auf einen für eine nachfolgende Digitalisierung geeigneten Pegel verstärkt. Der Verstärker 6 ist optional und kann auch weggelassen werden. Die Vorrichtung 10 umfasst weiterhin einen Analog-Digital-Wandler 7, der das von dem Verstärker 6 ausgegebene Signal digitalisiert.

Die Vorrichtung 10 umfasst weiterhin eine digitale Verarbeitungsvorrichtung 8, die wie im Nachfolgenden noch erläutert Kalibrierdaten speichern und unter Verwendung dieser Kalibrierdaten die von dem Analog-Digital-Wandler 7 ausgegebenen Daten über einen großen Dynamikbereich normalisieren beziehungsweise linearisieren kann.

Die Vorrichtung 10 umfasst weiterhin eine variable Spannungsquelle 9. Der optionale Schalter 5 schaltet den Eingang des Hüllkurvendetektors 4 zwischen der am Ausgang des Bandpassfilters 3 anliegenden verstärkten Photospannung und dem Ausgang der variablen Spannungsquelle 9 um.

Die Spannungsquelle 9 kann insbesondere ein variables Spannungssignal mit der gleichen oder einer ähnlichen Frequenz wie die zu detektierende Photospannung liefern.

Es besteht die Möglichkeit, dass die Spannungsquelle ein variables Spannungssignal generiert, das die gleiche oder eine ähnliche Frequenz wie das elektrische Signal aufweist, das aus dem optischen Signal erzeugt wird. Insbesondere können die von der variablen Spannungsquelle erzeugten Spannungssignale in einem Frequenzbereich liegen, der gleich, kleiner oder größer ist als der Frequenzbereich der aus dem optischen Signal erzeugten elektrischen Signale. Insbesondere kann dabei der Frequenzbereich der von der variablen Spannungsquelle erzeugten Spannungssignale den Frequenzbereich der aus dem optischen Signal erzeugten elektrischen Signale abdecken. Alternativ können die von der variablen Spannungsquelle erzeugten Spannungssignale auch nur eine einzelne Frequenz oder einen schmalen Frequenzbereich aufweisen, der in dem Frequenzbereich der aus dem optischen Signal erzeugten elektrischen Signale liegt.

Beispielsweise kann der Frequenzbereich der aus dem optischen Signal erzeugten elektrischen Signale zwischen 823,5 MHz und 935 MHz liegen. In diesem Fall können die von der variablen Spannungsquelle erzeugten Spannungssignale in einem Frequenzbereich liegen, der mindestens von 823,5 MHz bis 935 MHz reicht. Es besteht dabei durchaus die Möglichkeit, dass der Frequenzbereich der von der variablen Spannungsquelle erzeugten Spannungssignale größer ist, also beispielsweise von 800 MHz bis 960 MHz reicht. Alternativ kann bei diesem Beispiel auch vorgesehen sein, dass der Frequenzbereich der von der variablen Spannungsquelle erzeugten Spannungssignale kleiner ist und innerhalb des Frequenzbereichs der aus dem optischen Signal erzeugten elektrischen Signale liegt. Beispielsweise können die von der variablen Spannungsquelle erzeugten Spannungssignale eine konstante Frequenz von 890 MHz +/- 3 ppm aufweisen.

Die Amplituden der von der variablen Spannungsquelle erzeugten Spannungssignale ändern sich mit der Betriebsstemperatur und der Zeit nur um einem vernachlässigbar kleinen Betrag, wobei insbesondere die exakten Werte dieser Änderung im Gerät hinterlegt sein können.

Der Ausgang der Spannungsquelle 9 sollte über den gesamten Bereich der zu erwartenden Photospannungen einstellbar sein.

Alternativ kann die Signalumschaltung auch durch Ein- und Ausschalten der variablen Spannungsquelle 9 oder des als Signalquelle dienenden optischen Detektors 1 beziehungsweise des Verstärkers 2 erreicht werden.

Die Spannungsquelle 9 kann für die Kalibrierung des Hüllkurvendetektors 4 und etwaiger Verstärker 6 hinter der Schalterstellung über den gesamten zu messenden Spannungsbereich verwendet werden. Die Kalibrierung kann oder sollte bei mehreren, in geeigneter Weise über den Betriebstemperaturbereich des Hüllkurvendetektors 4 verteilten Temperaturen durchgeführt werden. Durch einen derartigen Aufbau können idealerweise jegliche Nichtlinearitäts- und Temperatureffekte auf die Empfängerkomponenten hinter der Schalterstellung nahezu vollständig ausgelöscht werden.

Die Spannungsquelle 9 kann dauerhaft oder vorübergehend an den Hüllkurvendetektor 4 beziehungsweise den Schalter 5 angeschlossen werden. Eine vorübergehend angeschlossene Spannungsquelle 9 kann zur Kalibrierung während der Herstellung oder Wartung des Hüllkurvendetektors 4 und gegebenenfalls des Verstärkers 6 verwendet werden. Die vollständigen Kalibrierdaten werden dann in der digitalen Verarbeitungsvorrichtung 8 gespeichert und zur numerischen Kalibrierung oder Korrektur der von dem Analog-Digital-Wandler 7 erzeugten Signale verwendet.

Eine fest integrierte Spannungsquelle 9 kann für die Aufnahme von Kalibrierdaten zu jedem geeigneten Zeitpunkt zwischen den Lichtmessungen verwendet werden. Eine solche Kalibrierung mit einer integrierten Spannungsquelle 9 kann präziser sein, weil sie sich auf den aktuellen Zustand der Systeme bezieht.

Aus Fig. 2 ist eine erste Ausführungsform einer Vorrichtung 20 zur ortsaufgelösten Messung von Temperatur und Dehnung vermittels Brillouin-Streuung ersichtlich. Bei der in Fig. 2 abgebildeten Vorrichtung 20 wird eine optische Überlagerung mit der für die Anregung der Brillouin-Streuung eingesetzten Laserstrahlung genutzt.

Die in Fig. 2 abgebildete Vorrichtung 20 umfasst eine Laserlichtquelle 11, die schmalbandige Laserstrahlung emittiert, beispielsweise mit einer Linienbreite von 1 MHz. Weiterhin weist die Laserstrahlung der Laserlichtquelle 1 eine konstante Leistung von beispielsweise einigen 10 mW auf. Vorzugsweise werden als Laserlichtquelle 11 frequenzstabilisierte Diodenlaser wie beispielsweise ein DFB-Laser oder andere schmalbandige Laser verwendet, deren Emissionswellenlänge im nahen Infrarotbereich angeordnet sind, beispielsweise bei 1550 nm.

Die in Fig. 2 abgebildete Vorrichtung 20 umfasst weiterhin einen als faseroptischer Teiler ausgebildeten Strahlteiler 12, der die Laserstrahlung der Laserlichtquelle 11 in zwei Anteile 13a, 13b aufteilen kann. Der erste Anteil 13a wird in die zur Messung verwendete Lichtleitfaser 14 eingekoppelt, in der über die Anregung von Brillouin-Streuung Temperatur und Dehnung ortsaufgelöst bestimmt werden sollen. Der zweite Anteil 13b wird für die Überlagerung mit einem aus der Lichtleitfaser 14 ausgekoppelten, durch die Brillouin-Streuung erzeugten Brillouin-Signal verwendet, wie im Nachfolgenden noch detaillierter beschrieben wird.

Die Vorrichtung umfasst weiterhin einen optischen Modulator 15, der den ersten Anteil 13a der Laserstrahlung entsprechend dem verwendeten Verfahren für die örtliche Zuordnung der Streusignale modulieren kann. Beispielsweise werden aus dem ersten Anteil 13a bei der Verwendung eines OTDR- Verfahrens (optical time domain reflectometry), Pulse und bei der Verwendung eines OFDR-Verfahrens (optical frequency domain reflectometry) amplitudenmodulierte Signale geformt. Ein nicht abgebildeter optischer Verstärker kann den für die Messung verwendeten ersten Anteil 13a der Laserstrahlung verstärken, bevor er über einen ebenfalls von der Vorrichtung umfassten optischen, insbesondere faseroptischen, Zirkulator 16 in die zur Messung verwendete Lichtleitfaser 14 geleitet wird.

In der zur Messung verwendeten Lichtleitfaser 14 entstehen Brillouin-Streusignale, die mit einer der Entfernung entsprechenden Laufzeitverzögerung von etwa 10 µs/km zurück zum optischen Zirkulator 16 kommen und von diesem in den Empfangspfad 17 der Vorrichtung geleitet werden. Ein nicht dargestellter, optionaler optischer Filter wie beispielsweise ein Faser-Bragg-Gitter (FBG) kann zur Unterdrückung von Rayleigh-Streulicht eingesetzt werden, um eine Störung der Messung des schwächeren Brillouin-Signals zu vermeiden. Weiterhin kann in dem Empfangspfad 17 eine optische Verstärkung durch einen optionalen optischen Verstärker 18 erfolgen.

Das Brillouin-Signal und der zweite Anteil 13b der Laserstrahlung werden durch einen optischen, insbesondere faseroptischen, Koppler 19 gekoppelt. Die Vorrichtung 20 umfasst als Vorrichtung zur Digitalisierung eines optischen Signals eine Vorrichtung 10 gemäß Fig. 1. Dabei wird von dem optischen Detektor 1 das mit dem zweiten Anteil 13b der Laserstrahlung überlagerte Brillouin-Signal detektiert.

Insbesondere entsteht dabei ein Schwebungssignal mit der Differenzfrequenz zwischen Brillouin-Signal und Laserstrahlungsanteil im Bereich um 10 GHz. Dieses Schwebungssignal ist hinsichtlich seiner Frequenz und seiner Amplitude abhängig von dem Material des für die Messung verwendeten Lichtleiters 14, der Temperatur und der Dehnung.

Die Amplitude des Schwebungssignals ist proportional zur Wurzel aus dem Produkt der Leistungen von Brillouin-Signal und Laserstrahlungsanteil. Durch Einsatz hoher Laserleistungen entsteht also ein deutlich stärkeres Messsignal als bei direkter Messung des Brillouin-Streulichts, wodurch die Nachweisstärke der Vorrichtung erheblich verbessert wird.

Die Vorrichtung 30 gemäß Fig. 3 weist im Unterschied zur Vorrichtung 20 gemäß Fig. 2 zusätzlich zu der ersten Laserlichtquelle 11 eine zweite schmalbandige Laserlichtquelle 21 auf, deren Laserstrahlung zur Überlagerung mit dem Brillouin-Signal eingesetzt wird. Dabei wird die Frequenz dieser zweiten Laserlichtquelle 21 gerade so eingestellt, dass sie so gegenüber der Frequenz der ersten Laserlichtquelle 11 verschoben ist, dass die Differenzfrequenz zwischen Brillouin-Streulicht und zweiter Laserlichtquelle 21 unterhalb 1 GHz liegt. Typische Brillouin-Frequenzen liegen bei 10 bis 13 GHz, insbesondere bei einer Standard-Single-Mode-Faser bei etwa 10,8 GHz.

Es soll an dieser Stelle angemerkt werden, dass auch die Temperaturabhängigkeit des Brillouin-Peaks faserspezifisch ist und beispielsweise bei einer Standard-Single-Mode-Faser bei etwa 1,1 MHz / Kelvin liegt.

Beispielsweise bei der Verwendung von Quarzglaslichtleitern ist eine Frequenzverschiebung der beiden Laserlichtquellen 11, 21 zueinander von etwas mehr als 10 GHz erforderlich, um eine Differenzfrequenz zwischen Brillouin-Streulicht und zweiter Laserlichtquelle 21 unterhalb 1 GHz zu erzielen.

Durch die unterhalb von 1 GHz liegende Differenzfrequenz kann ein optischer Detektor 1 mit einer Grenzfrequenz unter 1 GHz eingesetzt werden, der eine niedrigere Nachweisgrenze aufweist. Außerdem ist die Verstärkung und Filterung der Signale in diesem Frequenzbereich einfacher und effizienter.

Für die Stabilisierung der zweiten Laserlichtquelle 21 auf den gewünschten Frequenzabstand zur ersten Laserlichtquelle 11 wird eine nachfolgend O-PLL (optical phase locked loop) 22 genannte, lediglich schematisch dargestellte Phasenregelschleife mit optischem Eingangssignal eingesetzt. Ein Teil der Laserstrahlung beider Laserlichtquellen 11, 21 wird über als faseroptischer Teiler ausgebildeten Strahlteiler 12, 23 abgetrennt, mit einem faseroptischen Koppler polarisationsrichtig zusammengeführt und auf einem optischen Detektor überlagert. Das gemessene Signal enthält einen Anteil bei der Differenzfrequenz beider Laserlichtquellen 11, 21, die im Bereich um 10 GHz liegen soll. Die Frequenz des Signals wird in der O-PLL 22 mit der Frequenz eines elektronischen lokalen Oszillators verglichen, der auf die gewünschte Differenzfrequenz eingestellt wurde. Die Frequenz einer der beiden Laserlichtquellen 11, 21 wird anhand des Vergleichssignals so nachgestellt, dass die Differenzfrequenz der Laserlichtquellen 11, 21 mit der des lokalen Oszillators übereinstimmt. Falls Diodenlaser eingesetzt werden, erfolgt die Einstellung der Laserfrequenz vorzugsweise über den Betriebsstrom.

Das Brillouin-Signal wird mit einem Anteil der von der zweiten Laserlichtquelle 21 ausgehenden Laserstrahlung in dem Koppler 19 überlagert. Die Vorrichtung 30 umfasst ebenfalls als Vorrichtung zur Digitalisierung eines optischen Signals eine Vorrichtung 10 gemäß Fig. 1. Dabei wird von dem optischen Detektor 1 das mit dem Anteil der von der zweiten Laserlichtquelle 21 ausgehenden Laserstrahlung überlagerte Brillouin-Signal detektiert. Dabei kann sowohl die Frequenz als auch die Amplitude der Brillouin-Signale bestimmt werden.

Die Vorrichtung 10 misst dabei die Amplitude bei einer bestimmten, von dem Bandpassfilter 3 abgetrennten Frequenz, die durch die Frequenzdifferenz zwischen Brillouin-Signalfrequenz und dem Frequenzabstand der beiden Laserlichtquellen 11, 21 gegeben ist. Die Frequenzmessung besteht darin, nacheinander die Amplituden bei verschiedenen Frequenzen zu messen und dann die Peakfrequenz aus einem Peakfit der Amplituden über der Frequenz zu bestimmen.

## Patentansprüche

1. Vorrichtung (10) zur Digitalisierung eines optischen Signals, umfassend
- einen optischen Detektor (1), der dazu eingerichtet ist, ein optisches Signal zu erfassen und ein dem optischen Signal entsprechendes elektrisches Signal zu erzeugen,
- einen Hüllkurvendetektor (4), der dazu eingerichtet ist, die Amplitude des von dem optischen Detektor (1) erzeugten elektrischen Signals oder die Amplitude eines aus diesem elektrischen Signal hervorgegangenen elektrischen Signals zu bestimmen und ein dieser Amplitude entsprechendes elektrisches Signal auszugeben,
- einen Analog-Digital-Wandler (7), der dazu eingerichtet ist, das von dem Hüllkurvendetektor (4) ausgegebene elektrische Signal zu digitalisieren und entsprechende Daten auszugeben,
- eine variable Spannungsquelle (9) mit einem Ausgang, der mit einem Eingang des Hüllkurvendetektors (4) verbunden oder verbindbar ist, wobei die Vorrichtung dazu eingerichtet ist, den Hüllkurvendetektor (4) mit der variablen Spannungsquelle (9) zu kalibrieren.

2. Vorrichtung (10) nach Anspruch 1, **dadurch gekennzeichnet, dass** die Vorrichtung (10) einen Bandpassfilter (3) umfasst, der zwischen dem optischen Detektor (1) und dem Hüllkurvendetektor (4) angeordnet ist, wobei der Bandpassfilter (3) dazu eingerichtet ist, aus dem von dem optischen Detektor (1) erzeugten elektrischen Signal einen Gleichstromanteil und/oder mindestens einen Frequenzbereich herauszufiltern, der bei der Bestimmung der Amplitude durch den Hüllkurvendetektor (4) nicht benötigt wird und/oder sich als störend erweist.

3. Vorrichtung (10) nach einem der Ansprüche 1 oder 2, **dadurch gekennzeichnet, dass** die Vorrichtung (10) einen Verstärker (2) umfasst, der zwischen dem optischen Detektor (1) und dem Hüllkurvendetektor (4) oder zwischen dem optischen Detektor (1) und dem Bandpassfilter (3) angeordnet ist, wobei der Verstärker (2) dazu eingerichtet ist, das von dem optischen Detektor (1) erzeugte elektrische Signal zu verstärken, wobei der Verstärker (2) insbesondere ein Transimpedanz-Verstärker ist.

4. Vorrichtung (10) nach einem der Ansprüche 1 bis 3, **dadurch gekennzeichnet, dass** die Vorrichtung (10) einen Schalter (5) umfasst, der einerseits zwischen dem optischen Detektor (1) oder dem Verstärker (2) oder dem Bandpassfilter (3) und dem Hüllkurvendetektor (4) sowie andererseits zwischen der variablen Spannungsquelle (9) und dem Hüllkurvendetektor (4) angeordnet ist, wobei der Schalter (9) dazu eingerichtet ist, entweder das mittelbar oder unmittelbar von dem optischen Detektor (1) erzeugte elektrische Signal auf den Eingang des Hüllkurvendetektors (4) zu geben oder den Ausgang der variablen Spannungsquelle (1) mit dem Eingang des Hüllkurvendetektors (4) zu verbinden.

5. Vorrichtung (10) nach einem der Ansprüche 1 bis 4, **dadurch gekennzeichnet, dass** die Vorrichtung (10) einen Verstärker (6) umfasst, der zwischen dem Hüllkurvendetektor (4) und dem Analog-Digital-Wandler (7) angeordnet ist, wobei der Verstärker (6) dazu eingerichtet ist, das von dem Hüllkurvendetektor (4) erzeugte elektrische Signal zu verstärken.

6. Vorrichtung (10) nach einem der Ansprüche 1 bis 5, **dadurch gekennzeichnet, dass** die Vorrichtung (10) eine digitale Verarbeitungsvorrichtung (8) umfasst, die dazu eingerichtet ist, bei der Kalibrierung des Hüllkurvendetektors (4) erzeugte Kalibrierdaten zu speichern und unter Verwendung dieser Kalibrierdaten die von dem Analog-Digital-Wandler (7) ausgegebenen Daten zu normalisieren.

7. Verfahren zur Digitalisierung eines optischen Signals, umfassend folgende Verfahrensschritte:
- Es wird ein optisches Signal erfasst und ein dem optischen Signal entsprechendes elektrisches Signal erzeugt,
- von einem Hüllkurvendetektor (4) wird die Amplitude des erzeugten elektrischen Signals oder die Amplitude eines aus diesem elektrischen Signal hervorgegangenen elektrischen Signals bestimmt und ein dieser Amplitude entsprechendes elektrisches Signal ausgegeben,
- das von dem Hüllkurvendetektor (4) ausgegebene elektrische Signal wird digitalisiert und der Digitalisierung entsprechende Daten werden ausgegeben,
- mit einer variablen Spannungsquelle (9) wird der Hüllkurvendetektor (4) kalibriert.

8. Verfahren nach Anspruch 7, **dadurch gekennzeichnet, dass** bei der Kalibrierung des Hüllkurvendetektors (4) von der variablen Spannungsquelle (9) mehrere voneinander verschiedene Spannungen erzeugt werden, die auf einen Eingang des Hüllkurvendetektors (4) gegeben werden.

9. Verfahren nach einem der Ansprüche 7 oder 8, **dadurch gekennzeichnet, dass** die Kalibrierung des Hüllkurvendetektors (4) bei mehreren voneinander verschiedenen Temperaturen des Hüllkurvendetektors (4) durchgeführt wird.

10. Verfahren nach einem der Ansprüche 7 bis 9, **dadurch gekennzeichnet, dass** bei der Kalibrierung des Hüllkurvendetektors (4) Kalibrierdaten erzeugt werden, die abgespeichert und zur Normalisierung der ausgegebenen Daten verwendet werden.

11. Verfahren nach einem der Ansprüche 7 bis 10, **dadurch gekennzeichnet, dass** die Kalibrierung während der Herstellung oder Wartung der Vorrichtung (10) durchgeführt wird oder dass die Kalibrierung zwischen verschiedenen aufeinanderfolgenden Digitalisierungen optischer Signale durchgeführt wird.

12. Vorrichtung (20, 30) zur ortsaufgelösten Messung von Temperatur und Dehnung vermittels Brillouin-Streuung, umfassend
- mindestens eine Laserlichtquelle (11, 21), die dazu eingerichtet ist, eine Laserstrahlung zu erzeugen,
- eine Lichtleitfaser (14), wobei die Vorrichtung (20, 30) dazu eingerichtet ist, dass die von der mindestens einen Laserlichtquelle (11) erzeugte Laserstrahlung in die Lichtleitfaser (14) eingekoppelt wird und dass von der Laserstrahlung aufgrund von Brillouin-Streuung erzeugte Brillouin-Signale aus der Lichtleitfaser (14) ausgekoppelt werden,
- eine Vorrichtung (10) zur Digitalisierung eines optischen Signals, die dazu eingerichtet ist, die aus der Lichtleitfaser ausgekoppelten Brillouin-Signale zu digitalisieren,
**dadurch gekennzeichnet, dass** die Vorrichtung (10) zur Digitalisierung eines optischen Signals eine Vorrichtung (10) nach einem der Ansprüche 1 bis 6 ist.

13. Verfahren zur ortsaufgelösten Messung von Temperatur und Dehnung vermittels Brillouin-Streuung, umfassend folgende Verfahrensschritte:
- Es wird eine Laserstrahlung erzeugt,
- zur Messung von Temperatur und Dehnung wird die Laserstrahlung in eine Lichtleitfaser (14) eingekoppelt,
- von der Laserstrahlung in der Lichtleitfaser (14) erzeugte Brillouin-Signale werden aus der Lichtleitfaser ausgekoppelt,
- die aus der Lichtleitfaser (14) ausgekoppelten Brillouin-Signale werden mit einer Vorrichtung (10) zur Digitalisierung eines optischen Signals digitalisiert,
**dadurch gekennzeichnet, dass** die Vorrichtung (10) zur Digitalisierung eines optischen Signals eine Vorrichtung (10) nach einem der Ansprüche 1 bis 6 ist.

14. Verfahren nach Anspruch 13, **dadurch gekennzeichnet, dass** sowohl die Frequenz als auch die Amplitude der Brillouin-Signale bestimmt werden.

15. Verfahren nach Anspruch 14, **dadurch gekennzeichnet, dass** nacheinander die Amplituden der Brillouin-Signale bei verschiedenen Frequenzen gemessen werden und danach eine Peakfrequenz aus einem Peakfit der Amplituden über der Frequenz bestimmt wird.

## Claims

1. Device (10) for digitising an optical signal, comprising
- an optical detector (1) configured to detect an optical signal and to generate an electric signal corresponding to the optical signal;
- an envelope detector (4) configured to determine the amplitude of the electrical signal generated by the optical detector (1) or the amplitude of an electrical signal originating from this electrical signal and to output an electrical signal corresponding to this amplitude,
- an analogue-to-digital converter (7) configured to digitise the electrical signal output by the envelope detector (4) and to output corresponding data,
- a variable voltage source (9) having an output connected or connectable to an input of the envelope detector (4), wherein the device is configured to calibrate the envelope detector (4) with the variable voltage source (9).

2. Device (10) according to claim 1, **characterised in that** the device (10) comprises a bandpass filter (3) arranged between the optical detector (1) and the envelope detector (4), wherein the bandpass filter (3) is configured to filter out from the electrical signal generated by the optical detector (1) a direct current component and/or at least one frequency range which is not required and/or proves to be interfering when the amplitude is being determined by the envelope detector (4).

3. Device (10) according to any one of claims 1 or 2, **characterised in that** the device (10) comprises an amplifier (2) arranged between the optical detector (1) and the envelope detector (4) or between the optical detector (1) and the bandpass filter (3), wherein the amplifier (2) is configured to amplify the electrical signal generated by the optical detector (1), wherein the amplifier (2) is in particular a transimpedance amplifier.

4. Device (10) according to any one of claims 1 to 3, **characterised in that** the device (10) comprises a switch (5) arranged, on the one hand, between the optical detector (1) or the amplifier (2) or the bandpass filter (3) and the envelope detector (4) and, on the other hand, between the variable voltage source (9) and the envelope detector (4), wherein the switch (9) is configured either to send the electrical signal generated indirectly or directly by the optical detector (1) to the input of the envelope detector (4) or to connect the output of the variable voltage source (1) to the input of the envelope detector (4).

5. Device (10) according to any one of claims 1 to 4, **characterised in that** the device (10) comprises an amplifier (6) arranged between the envelope detector (4) and the analogue-to-digital converter (7), wherein the amplifier (6) is configured to amplify the electrical signal generated by the envelope detector (4).

6. Device (10) according to any one of claims 1 to 5, **characterised in that** the device (10) comprises a digital processing device (8) configured to store calibration data generated during the calibration of the envelope detector (4) and to normalise the data output from the analogue-to-digital converter (7) using this calibration data.

7. Method for digitising an optical signal, comprising the following method steps:
- an optical signal is detected and an electrical signal corresponding to the optical signal is generated,
- the amplitude of the generated electrical signal or the amplitude of an electrical signal originating from this electrical signal is determined by an envelope detector (4) and an electrical signal corresponding to this amplitude is output,
- the electrical signal output by the envelope detector (4) is digitised and data corresponding to the digitisation are output,
- the envelope detector (4) is calibrated with a variable voltage source (9).

8. Method according to claim 7, **characterised in that** during the calibration of the envelope detector (4) a plurality of mutually different voltages are generated by the variable voltage source (9), and are sent to an input of the envelope detector (4).

9. Method according to any one of claims 7 or 8, **characterised in that** the calibration of the envelope detector (4) is performed at a plurality of mutually different temperatures of the envelope detector (4).

10. Method according to any one of claims 7 to 9, **characterised in that** the calibration of the envelope detector (4) generates calibration data which are stored and used to normalise the output data.

11. Method according to any one of claims 7 to 10, **characterised in that** the calibration is performed during the production or maintenance of the device (10) or **in that** the calibration is performed between different successive digitisations of optical signals.

12. Device (20, 30) for spatially resolved measurement of temperature and strain by means of Brillouin scattering, comprising
- at least one laser light source (11, 21) configured to generate laser radiation,
- an optical fibre (14), wherein the device (20, 30) is configured such that the laser radiation generated by the at least one laser light source (11) is coupled into the optical fibre (14) and that Brillouin signals generated by the laser radiation due to Brillouin scattering are coupled out of the optical fibre (14),
- a device (10) for digitising an optical signal, which device is configured to digitise the Brillouin signals coupled out of the optical fibre,
**characterised in that** the device (10) for digitising an optical signal is a device (10) according to any one of claims 1 to 6.

13. Method for spatially resolved measurement of temperature and strain by means of Brillouin scattering, comprising the following method steps:
- laser radiation is generated,
- to measure temperature and strain, the laser radiation is coupled into an optical fibre (14),
- Brillouin signals generated by the laser radiation in the optical fibre (14) are coupled out of the optical fibre,
- the Brillouin signals coupled out of the optical fibre (14) are digitised by means of a device (10) for digitising an optical signal,
**characterised in that** the device (10) for digitising an optical signal is a device (10) according to any one of claims 1 to 6.

14. Method according to claim 13, **characterised in that** both the frequency and the amplitude of the Brillouin signals are determined.

15. Method according to claim 14, **characterised in that** the amplitudes of the Brillouin signals are successively measured at different frequencies and thereafter a peak frequency is determined from a peak fit of the amplitudes over the frequency.

## Revendications

1. Dispositif (10) de numérisation d'un signal optique, comprenant
- un détecteur optique (1) qui est conçu pour détecter un signal optique et pour générer un signal électrique correspondant au signal optique,
- un détecteur d'enveloppe (4) qui est conçu pour déterminer l'amplitude du signal électrique généré par le détecteur optique (1) ou l'amplitude d'un signal électrique résultant de ce signal électrique et pour émettre un signal électrique correspondant à ladite amplitude,
- un convertisseur analogique-numérique (7) qui est conçu pour numériser le signal électrique émis par le détecteur d'enveloppe (4) et pour émettre des données correspondantes,
- une source de tension variable (9) présentant une sortie qui est reliée ou peut être reliée à une entrée du détecteur d'enveloppe (4), dans lequel le dispositif est conçu pour calibrer le détecteur d'enveloppe (4) avec la source de tension variable (9).

2. Dispositif (10) selon la revendication 1, **caractérisé en ce que** le dispositif (10) comprend un filtre passe-bande (3) qui est agencé entre le détecteur optique (1) et le détecteur d'enveloppe (4), dans lequel le filtre passe-bande (3) est agencé pour filtrer, à partir du signal électrique généré par le détecteur optique (1), une composante de courant continu et/ou au moins une plage de fréquences qui n'est pas nécessaire et/ou qui s'avère perturbatrice lors de la détermination de l'amplitude par le détecteur d'enveloppe (4).

3. Dispositif (10) selon l'une quelconque des revendications 1 ou 2, **caractérisé en ce que** le dispositif (10) comprend un amplificateur (2) qui est agencé entre le détecteur optique (1) et le détecteur d'enveloppe (4) ou entre le détecteur optique (1) et le filtre passe-bande (3), dans lequel l'amplificateur (2) est agencé pour amplifier le signal électrique généré par le détecteur optique (1), dans lequel l'amplificateur (2) est en particulier un amplificateur à transimpédance.

4. Dispositif (10) selon l'une quelconque des revendications 1 à 3, **caractérisé en ce que** le dispositif (10) comprend un commutateur (5) qui est agencé d'une part entre le détecteur optique (1) ou l'amplificateur (2) ou le filtre passe-bande (3) et le détecteur d'enveloppe (4) et d'autre part entre la source de tension variable (9) et le détecteur d'enveloppe (4), dans lequel le commutateur (9) est conçu soit pour appliquer le signal électrique généré directement ou indirectement par le détecteur optique (1) à l'entrée du détecteur d'enveloppe (4), soit pour relier la sortie de la source de tension variable (1) à l'entrée du détecteur d'enveloppe (4).

5. Dispositif (10) selon l'une quelconque des revendications 1 à 4, **caractérisé en ce que** le dispositif (10) comprend un amplificateur (6) qui est agencé entre le détecteur d'enveloppe (4) et le convertisseur analogique-numérique (7), dans lequel l'amplificateur (6) est agencé pour amplifier le signal électrique généré par le détecteur d'enveloppe (4).

6. Dispositif (10) selon l'une quelconque des revendications 1 à 5, **caractérisé en ce que** le dispositif (10) comprend un dispositif de traitement numérique (8) qui est conçu pour stocker des données d'étalonnage générées lors de l'étalonnage du détecteur d'enveloppe (4) et pour normaliser, en utilisant ces données d'étalonnage, les données provenant du convertisseur analogique-numérique (7).

7. Procédé de numérisation d'un signal optique, comprenant les étapes de procédé suivantes :
- un signal optique est détecté et un signal électrique correspondant au signal optique est généré,
- à partir d'un détecteur d'enveloppe (4), l'amplitude du signal électrique généré ou l'amplitude d'un signal électrique résultant de ce signal électrique est déterminée et un signal électrique correspondant à cette amplitude est émis,
- le signal électrique émis par le détecteur d'enveloppe (4) est numérisé et des données correspondant à la numérisation sont émises,
- le détecteur d'enveloppe (4) est étalonné à l'aide d'une source de tension variable (9).

8. Procédé selon la revendication 7, **caractérisé en ce que,** lors de l'étalonnage du détecteur d'enveloppe (4), plusieurs tensions différentes les unes des autres sont générées par la source de tension variable (9) et sont appliquées à une entrée du détecteur d'enveloppe (4).

9. Procédé selon l'une quelconque des revendications 7 ou 8, **caractérisé en ce que** l'étalonnage du détecteur d'enveloppe (4) est effectué à plusieurs températures différentes les unes des autres du détecteur d'enveloppe (4).

10. Procédé selon l'une quelconque des revendications 7 à 9, **caractérisé en ce que,** lors de l'étalonnage du détecteur d'enveloppe (4), des données d'étalonnage sont générées, mémorisées et utilisées pour normaliser les données émises.

11. Procédé selon l'une quelconque des revendications 7 à 10, **caractérisé en ce que** l'étalonnage est réalisé pendant la fabrication ou la maintenance du dispositif (10) ou **en ce que** l'étalonnage est réalisé entre différentes numérisations successives de signaux optiques.

12. Dispositif (20, 30) pour la mesure à résolution spatiale de la température et de la dilatation au moyen de la diffusion Brillouin, comprenant
- au moins une source de lumière laser (11, 21), qui est conçue pour générer un rayonnement laser,
- une fibre optique (14), dans lequel le dispositif (20, 30) est conçu pour que le rayonnement laser généré par la au moins une source de lumière laser (11) soit couplé dans la fibre optique (14) et pour que des signaux de Brillouin générés par le rayonnement laser en raison de la diffusion de Brillouin soient découplés de la fibre optique (14),
- un dispositif (10) de numérisation d'un signal optique, qui est conçu pour numériser les signaux de Brillouin découplés de la fibre optique,
**caractérisé en ce que** le dispositif (10) de numérisation d'un signal optique est un dispositif (10) selon l'une quelconque des revendications 1 à 6.

13. Procédé de mesure à résolution spatiale de la température et de la dilatation au moyen de la diffusion Brillouin, comprenant les étapes de procédé suivantes :
- un rayonnement laser est généré
- le rayonnement laser est couplé à une fibre optique (14) pour la mesure de la température et de l'allongement,
- des signaux Brillouin générés par le rayonnement laser dans la fibre optique (14) sont découplés de la fibre optique,
- les signaux de Brillouin découplés de la fibre optique (14) sont numérisés par un dispositif (10) de numérisation d'un signal optique,
**caractérisé en ce que** le dispositif (10) de numérisation d'un signal optique est un dispositif (10) selon l'une quelconque des revendications 1 à 6.

14. Procédé selon la revendication 13, **caractérisé en ce que** la fréquence et l'amplitude des signaux de Brillouin sont toutes deux déterminées.

15. Procédé selon la revendication 14, **caractérisé en ce que** les amplitudes des signaux Brillouin sont mesurées successivement à différentes fréquences et **en ce qu'**une fréquence de pic est ensuite déterminée à partir d'une fusion de pics des amplitudes en fonction de la fréquence.
